# EUROPÄISCHE PATENTSCHRIFT

(11) **EP 1 034 456 B1**
(45) Veröffentlichungstag und Bekanntmachung des Hinweises auf die Patenterteilung: **07.05.2003**
(21) Anmeldenummer: 98963473.8
(22) Anmeldetag: 17.11.1998
(51) Int. Cl.: G03F 7/20

(54) **UV-OPTISCHES SYSTEM MIT REDUZIERTER ALTERUNG**
UV OPTICAL SYSTEM WITH REDUCED AGEING
SYSTEME OPTIQUE UV A VIEILLISSEMENT REDUIT

(30) Priorität: 28.11.1997 DE 19752713
(43) Veröffentlichungstag der Anmeldung: 13.09.2000
(73) Patentinhaber: Carl Zeiss, 89518 Heidenheim (Brenz) (DE); Carl-Zeiss-Stiftung, trading as Carl Zeiss, 89518 Heidenheim (Brenz) (DE)
(72) Erfinder: GERLINGER, Hermann, D-73432 Aalen (DE)
(86) Internationale Anmeldenummer: EP9807366
(87) Internationale Veröffentlichungsnummer: WO99028789

(56) Entgegenhaltungen:
- EP-A- 0 532 236
- EP-A- 0 687 956
- EP-B- 0 375 534
- DE-A- 3 342 995
- US-A- 5 621 843
- PATENT ABSTRACTS OF JAPAN vol. 012, no. 196 (E-618), 7. Juni 1988 -& JP 62 299026 A (NEC YAMAGATA LTD), 26. Dezember 1987

## Beschreibung

Die Erfindung betrifft ein optisches System mit einer Ultraviolett-Lichtquelle und mindestens einem refraktiven optischen Element, d.h., mit einer Linse oder einem Prisma.

Dabei ist besonders an Mikrolithographie-Projektionsbelichtungssysteme für den DUV-Bereich unterhalb der Hg-I-Linie gedacht, die vorwiegend Excimer-Laser als Lichtquellen benützen, aber z.B. auch an Optiken für Excimer-Laser in anderen Anwendungsbereichen.

Derartige Systeme finden sich beispielsweise in den Patentanmeldungen EP 0 687 956 A1, EP 0 658 810 A1 und DE 195 20 563 A der Anmelderin.

Durch die hohe Photonenenergie im DUV treten auch bei geeigneten transparenten Medien die Absorption erhöhende Langzeitschäden auf, bei Quarz als Bildung von Farbzentren. Daneben erfolgt die als "Compaction" bekannte Verdichtung des Materials.

Es ist aus JP-A 7/061828 bekannt, daß die Transmission von Quarz im Bereich 170 - 200 nm bei der Herstellung der Quarzkörper durch Druck- und Hitzebehandlung bei über 500° C verbessert werden kann.

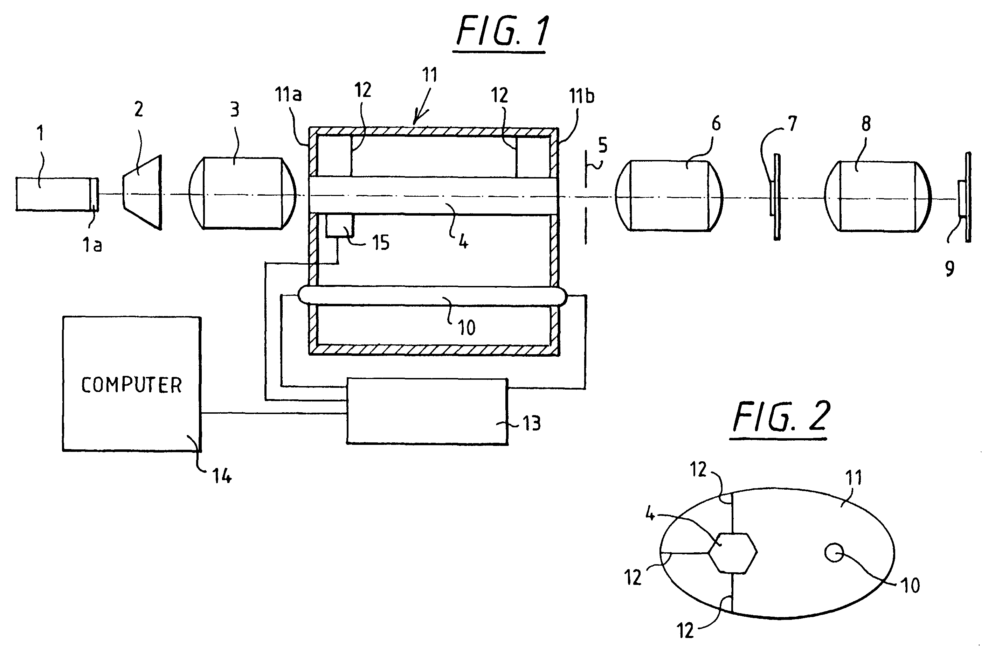

Aus EP 0 532 236 A ist ein System mit Synchrotronstrahlung oder Excimer-Laser hoher Leistung bekannt, bei dem ein optisches Element, speziell die Maske, zum Ausgleich von Formänderungen durch die Erwärmung unter der UV-Strahlung beheizt wird. Es werden nur Beispiele mit beheizten reflektierenden Elementen gezeigt, deren Temperatur unter 90° C (Fig. 6) bleibt und welche damit die ohne Heizung allein durch die UV-Strahlung erreichte Maximaltemperatur nur unwesentlich überschreitet (z.B. dort Fig. 2, 4).

Vor allem in der Halbleiter-Elektronik ist bekannt, daß erhöhte Betriebstemperatur zur Beschleunigung von Alterungsprozessen führt.

Es wurde festgestellt, daß Quarzglasteile, die durch hohe UV-Strahlendosis diese hohe Absorption durch Farbzentren zeigen, durch Ausheizen bis ca. 350° C wieder die ursprüngliche Transparenz erhalten können.

Auch wurde festgestellt, daß der Anstieg der Absorption mit der eingestrahlten UV-Strahlungsdosis (248 nm Excimer-Laser) bei höherer mittlerer Leistung (höhere Pulsfrequenz), bei der dann die Temperatur des Quarzes erhöht ist, langsamer verläuft.

Aus EP 0 375 534 B1 ist eine Photomaske und ein Herstellungsverfahren bekannt, bei dem die Maskenstruktur mittels Erzeugung von Farbzentren durch UV-Belichten, z.B. in CaF₂ mit 248 nm Wellenlänge, hergestellt wird. Durch Ausheizen kann die Struktur wieder beseitigt werden.

US 5,621,843 beschreibt eine Quarzglas-Lichtleitfaser für UV-Anwendungen unter 325 nm Wellenlänge. Es ist vorgesehen, die Lichtleitfaser auf einem Temperaturniveau von 200° C bis 400° C zu halten, wodurch die Rekombination von Farbzentren mit ihrer Entstehung in ein Gleichgewicht gebracht wird bei minimaler Konzentration. Verschiedene Beheizungsmethoden sind angegeben.

Aus Fan Piao et al, SPIE Microlithography 1997, Band 3051, Seite 907 ff ist bekannt, daß auch die Compaction durch erhöhte Temperatur positiv beeinflußt wird.

Aufgabe der Erfindung ist es, ein gattungsgemäßes optisches System anzugeben, das erhöhte Beständigkeit gegen UV-Strahlung aufweist.

Gelöst wird diese Aufgabe durch ein optisches System mit den kennzeichnenden Merkmalen des Anspruches 1, bei dem also mindestens ein optisches Element bei einer Betriebstemperatur von über 100° C liegt. Entsprechendes gilt für Anspruch 9. Durch die Erfindung wird also von dem vollständig verbreiteten Gebrauch abgewichen, optische Systeme in Herstellung und Gebrauch möglichst durchgehend nahe an Normaltemperatur zu halten.

Die US 5,621,843 belegt, daß durch erhöhte Temperatur die Farbzentrenbildung stabilisiert werden kann. Die bei klassischen optischen Elementen entstehenden Probleme der Wärmeausdehnung u.ä. können mit Fassungstechniken, wie sie von satellitengestützten optischen Systemen bekannt sind, gelöst werden.

Das optische Design kann die Form bei erhöhter Betriebstemperatur in der Optikrechnung festlegen und für die Produktion bei herkömmlicher Temperatur die geänderten Formparameter aufgrund der thermischen Ausdehnung bestimmen.

Kitte als Verbindungsmittel zwischen Quarzglas und metallischer Fassung können durch Ganzmetall-Techniken ersetzt werden, z.B. durch Galvanoplastik gemäß DD 204 320, allerdings vorzugsweise nicht mit einem ganzen Metallring, sondern mit mehreren lokalen Ansätzen.

Hochpräzise Aufhängungen zur spannungsfreien Verbindung von Teilen mit verschiedener Wärmeausdehnung sind bekannt, z.B. aus DE 296 03 024 U 1 der Anmelderin und dem darin genannten Stand der Technik.

Vorzugsweise wird die erhöhte Betriebstemperatur in den am höchsten mit UV-Strahlung belasteten Teilen eines optischen Systems angewendet, d.h. also im Beleuchtungssystem nach Anspruch 2.

Nach Anspruch 3 ist die bevorzugte Lichtquelle ein Excimer-Laser, da hier hohe Strahlungs-Leistungsdichten bei kurzen Wellenlängen (insbesondere 248 nm, 193 nm, 157 nm) erzielt werden.

Bevorzugte Anwendung findet die Erfindung bei Projektionsbelichtungssystemen für die Mikrolithographie gemäß Anspruch 4, da dies sehr aufwendige Optiken sind, bei denen eine Steigerung der Lebensdauer und eine Stabilisierung der optischen Eigenschaften große wirtschaftliche Bedeutung hat.

Der in einigen Beleuchtungssystemen von Projektionsbelichtungsanlagen, z.B. den obengenannten, eingesetzte Glasstab als Lichtmisch-Element (Kaleidoskop) ist besonders für die erhöhte Betriebstemperatur prädestiniert (Anspruch 5). Er ist ein Element sehr nahe an der Lichtquelle mit hoher Strahlungsintensität und großem Lichtweg, also großer Absorptionslänge.

Er kann beispielsweise beheizt werden durch eine parallel liegende IR-Strahlungsquelle mit einem elliptisch-zylindrischen Spiegel, ähnlich bekannten Pumpanordnungen für Laser.

Auch andere Teile, Linsen und Linsengruppen können beheizt werden, insbesondere die ganze Beleuchtungsoptik. Aber auch die ganze Optik der Projektionsbelichtungsanlage, inkl. Retikel, kann beheizt werden.

Für die Kompensation der Farbzentrenbildung ist die genaue Temperatur der Quarzglasteile weniger wichtig, da es sich um einen thermodynamischen Effekt handelt. Genaue und stabile Temperaturregelung ist aber wegen der optischen Wirkungen erforderlich. Langsame Aufheizung ist zur Vermeidung thermischer Spannungen vorgesehen.

Bevorzugt findet die Erfindung bei Quarzglas-Elementen oder Kalziumfluorid-Elementen gemäß Anspruch 6 Anwendung.

Die entsprechenden Verfahren sind Gegenstand der Ansprüche 9-11.

Die Betriebstemperatur wird - oberhalb etwa 100° C - wegen der thermischen Deformationen usw. möglichst niedrig gehalten. Während der UV-Beleuchtung kann die Zahl der Farbzentren zunehmen, da durch die Pulspausen des Excimer-Lasers und durch Ausblenden des Laserlichts in Betriebspausen, z.B. bei Stellungswechsel des Steppers oder Waferwechsel, Zeiten mit reiner Rekombination zum Ausgleich zur Verfügung stehen.

Daneben kann auch in Stillstandzeiten beheizt werden, wobei dann bei erhöhter Temperatur auch die optischen Spezifikationen verletzt werden dürfen. Dabei läßt sich dann der Farbzentrenbestand abbauen.

Näher erläutert wird die Erfindung anhand der Zeichnungen.
- Figur 1: zeigt schematisch eine Mikrolithographie-Projektionsbelichtungsanlage mit strahlungsbeheiztem Glasstab;
- Figur 2: zeigt dazu schematisch im Querschnitt die Strahlungsheizung des Glasstabs;
- Figur 3: zeigt schematisch eine Projektionsbelichtungsanlage mit Heizung des Beleuchtungssystems.

Die Projektionsbelichtungsanlage der Figur 1 besteht in einer als Wafer-Stepper und Wafer-Scanner bekannten Art und Weise aus einem Excimer-Laser 1 mit z.B. 248 nm oder 193 nm Wellenlänge im tiefen (Vakuum-) UV, einem Strahlaufweitungssystem 2, einer Anpassungsoptik mit Zoom und Axicon, einem Glasstab 4 zur Mischung und Homogenisierung des Lichts, einer Retikel-Maskierblende 5, einem REMA-Objektiv 6, dem Retikel 7, einem Projektionsobjektiv 8 und dem Wafer 9, der belichtet wird.

Hier ist erfindungsgemäß der Glasstab 4 mit Halterungen 12 in einem elliptischen Zylinderspiegel 11 in einer Brennlinie angeordnet. In der zweiten Brennlinie befindet sich ein IR-Strahler 10. Im einfachsten Fall ist dies ein elektrisch betriebener Heizdraht. Andere Systeme sind z.B. gezielt abgestimmt auf bestimmte Absorptionsbanden des Glasstabs 4 - der aus speziell optimiertem DUV-strahlungstauglichem Quarzglas z.B. nach EP 0 401 845 besteht, wie auch die anderen transmittierenden optischen Bauteile mit Ausnahme eventuell einiger Elemente aus Kalziumfluorid.

Die Halterungen 12 sind mit Konstruktion und Materialauswahl so ausgelegt, daß der Glasstab 4 bei Betriebstemperatur zentriert auf der optischen Achse A des Systems liegt und daß er bei allen Temperaturen von Raumtemperatur (Lagertemperatur) bis Betriebstemperatur minimalen Spannungen ausgesetzt ist, so daß u.a. kein störende Spannungsdoppelbrechung auftritt.

Die Versorgungseinheit 13 steuert und regelt den IR-Strahler 10 im Zusammenwirken mit einem oder mehreren Temperatursensoren 15 und mit dem System-Computer 14 so, daß die ausgewählte Betriebstemperatur stabil gehalten wird. Die Betriebstemperatur liegt vorzugsweise im Bereich von 150° C bis 250° C und ist im Einzelfall aus Konstruktion und Strahlungsbelastung zu ermitteln.

Endabschirmungen 11a, 11b des elliptischen Zylinderspiegels 11 dienen der Abschirmung der benachbarten Baugruppen 3, 5, 6 von der Wärmestrahlung. Zum gleichen Zweck können auf den Endflächen des Glasstabs 4 und/oder auf den nächstliegenden Flächen der Linsengruppen 3, 6 dichroitische Schichten angeordnet werden.

Andere bevorzugt zu beheizende optische Elemente sind das Austrittsfenster 1a des Excimer-Lasers 1 und die Baugruppen 2 oder 3 zur Gänze oder teilweise.

Figur 2 zeigt einen Querschnitt durch die Anordnung der Figur 1 im Bereich des Glasstabs 4. In der bei Pumpoptiken für mit Blitzlampen gepumpte Laserstäbe bekannten Anordnung wird das aus dem Bereich einer Brennlinie vom IR-Strahler 10 emittierte IR-Licht durch den elliptisch zylindrischen Spiegel 11, der natürlich auch eine Näherungsform aufweisen kann, auf den um die zweite Brennlinie zentrierten Glasstab 4 reflektiert und darin absorbiert, wobei eine weitgehend gleichmäßige Beheizung von allen Seiten erfolgt.

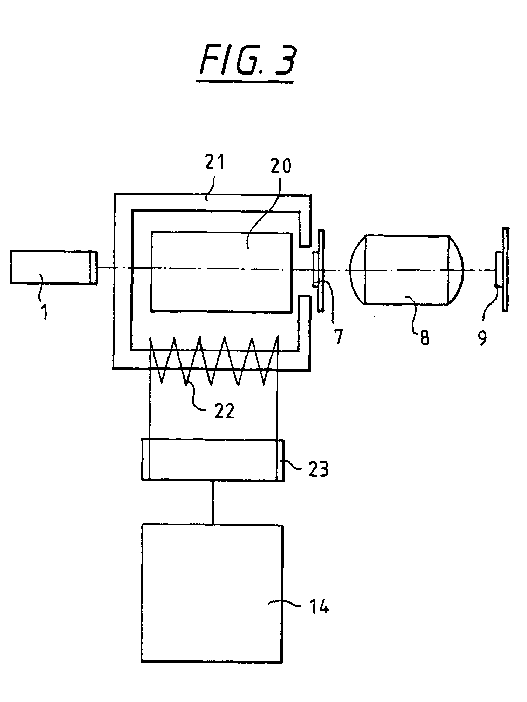

Figur 3 zeigt ein zweites Ausführungsbeispiel. Hier ist die gesamte Beleuchtungseinrichtung 20, die z.B. die Baugruppen 2 bis 6 der Figur 1 umfaßt, beheizt in einer Hülle 21 angeordnet, welche durch ein Heizelement 22 und eine Regeleinheit 23 unter Kontrolle des Hauptcomputers 14 die stabile erhöhte Betriebstemperatur sicherstellt. Das Retikel 7, das Projektionsobjektiv 8 und der Wafer 9 sind auf üblicher Temperatur. Lediglich der Wafer 9 kann regelmäßig nicht auf die erhöhten Temperaturen oberhalb 100° C gebracht werden, da sonst zerstörende Prozesse in ihm ablaufen. Retikel 7 und Projektionsobjektiv 8 können aber grundsätzlich auch beheizt werden, mit den gleichen oben beschriebenen Vorteilen.

## Patentansprüche

1. Ein als Projektionsbelichtungssystem für die Mikrolithographie ausgebildetes optisches System mit einer Ultraviolett-Lichtquelle (1) und mindestens einem ersten refraktiven optischen Element (2, 3, 4, 6, 8), **dadurch gekennzeichnet, dass** das optische System eine Vorrichtung (10, 11, 21, 22, 23) zur Bereitstellung einer Betriebstemperatur über 100°C bei dem ersten refraktiven optischen Element (2, 3, 4, 6) anders als durch die Strahlung der Ultraviolett-Lichtquelle (1) aufweist.

2. Optisches System nach Anspruch 1, weiter **dadurch gekennzeichnet, dass** es ein Beleuchtungssystem (20) und ein Abbildungssystem (8) enthält und das erste refraktive optische Element (2, 3, 4, 6) im Beleuchtungssystem (20) angeordnet ist.

3. Optisches System nach Anspruch 1 oder 2, weiter **dadurch gekennzeichnet, dass** die Ultraviolett-Lichtquelle (1) ein Excimer-Laser ist.

4. Optisches System nach mindestens einem der Ansprüche 1-3, weiter **dadurch gekennzeichnet, dass** es mindestens eine Linse (2, 3, 6, 8) enthält und die Betriebstemperatur der Linse (2, 3, 6, 8) über 100°C beträgt.

5. Optisches System nach mindestens einem der Ansprüche 1-4, weiter **dadurch gekennzeichnet, dass** es einen Glasstab (4) als lichtmischendes Element enthält und bei dem Glasstab (4) die Betriebstemperatur über 100°C beträgt.

6. Optisches System nach mindestens einem der Ansprüche 1-5, weiter **dadurch gekennzeichnet, dass** das erste refraktive optische Element aus Quarzglas oder Kalziumfluorid ist.

7. Optisches System nach mindestens einem der Ansprüche 1-6, weiter **dadurch gekennzeichnet, dass** die Betriebstemperatur im Bereich von 150°C bis 250°C liegt.

8. Optisches System nach mindestens einem der Ansprüche 1-7, weiter **dadurch gekennzeichnet**, das zumindest ein Teil des optischen Systems, anders als das erste refraktive optische Element, hitzefest für Temperaturen oberhalb 100°C ausgebildet ist.

9. Verfahren zum Betrieb eines Mikrolithographie-Projektionsbelichtungssystems mit einer Ultraviolett-Lichtquelle (1) und mindestens einem ersten refraktiven optischen Element (2, 3, 4, 6, 8), **dadurch gekennzeichnet, dass** das erste refraktive optische Element (2, 3, 4, 6) mit einer Vorrichtung (10, 11, 21, 22, 23) zur Bereitstellung einer Betriebstemperatur über 100°C anders als durch die Strahlung der Ultraviolett-Lichtquelle auf dieser Betriebstemperatur gehalten wird.

10. Verfahren nach Anspruch 9, weiter **dadurch gekennzeichnet, dass** die Betriebstemperatur des ersten refraktiven optischen Elements (2, 3, 4, 6) bei einem Wert im Bereich von 150°C bis 250°C gehalten wird.

11. Verfahren nach Anspruch 9 oder Anspruch 10, weiter **dadurch gekennzeichnet, dass** das erste refraktive optische Element (2, 3, 4, 6) strahlungsbeheizt wird.

## Claims

1. Optical system designed as a projection exposure system for microlithography and having an ultraviolet light source (1) and at least one first refractive optical element (2, 3, 4, 6, 8), **characterized in that** the optical system has a device (10, 11, 21, 22, 23) for providing an operating temperature above 100°C at the first refractive optical element (2, 3, 4, 6) differently than by the radiation of the ultraviolet light source (1).

2. Optical system according to Claim 1, further **characterized in that** it contains an illumination system (20) and an imaging system (8) and the first refractive optical element (2, 3, 4, 6) is arranged in the illumination system (20).

3. Optical system according to Claim 1 or 2, further **characterized in that** the ultraviolet light source (1) is an excimer laser.

4. Optical system according to at least one of Claims 1-3, further **characterized in that** it contains at least one lens (2, 3, 6, 8) and the operating temperature of the lens (2, 3, 6, 8) is above 100°C.

5. Optical system according to at least one of Claims 1-4, further **characterized in that** it contains a glass bar (4) as light-mixing element and at the glass bar (4) the operating temperature is above 100°C.

6. Optical system according to at least one of Claims 1-5, further **characterized in that** the first refractive optical element is made of quartz glass or calcium fluoride.

7. Optical system according to at least one of Claims 1-6, further **characterized in that** the operating temperature lies in the range from 150°C to 250°C.

8. Optical system according to at least one of Claims 1-7, further **characterized in that** at least a part of the optical system, differently than the first refractive optical element, is designed to be heat-resistant for temperatures above 100°C.

9. Method for operating a microlithography projection exposure system having an ultraviolet light source (1) and at least one first refractive optical element (2, 3, 4, 6, 8), **characterized in that** the first refractive optical element (2, 3, 4, 6) is held at an operating temperature above 100°C by a device (10, 11, 21, 22, 23) for providing the said operating temperature differently than by the radiation of the ultraviolet light source.

10. Method according to Claim 9, further **characterized in that** the operating temperature of the first refractive optical element (2, 3, 4, 6) is held at a value in the range from 150°C to 250°C.

11. Method according to Claim 9 or Claim 10, further **characterized in that** the first refractive optical element (2, 3, 4, 6) is radiation-heated.

## Revendications

1. Système optique sous la forme d'un système d'éclairage par projection pour la microlithographie avec une source de lumière ultraviolette (1) et au moins un premier élément optique réfractif (2, 3, 4, 6, 8), **caractérisé en ce que** le système optique présente un dispositif (10, 11, 21, 22, 23) pour produire une température de fonctionnement supérieure à 100°C pour le premier élément optique réfractif (2, 3, 4, 6) par d'autres moyens que le rayonnement de la source de lumière ultraviolette (1).

2. Système optique suivant la revendication 1, **caractérisé en outre en ce qu'**il contient un système d'éclairage (20) et un système de représentation (8) et **en ce que** le premier élément optique réfractif (2, 3, 4, 6) est disposé dans le système d'éclairage (20).

3. Système optique suivant la revendication 1 ou 2, **caractérisé en outre en ce que** la source de lumière ultraviolette (1) est un laser excimer.

4. Système optique suivant au moins une des revendications 1 à 3, **caractérisé en outre en ce qu'**il contient au moins une lentille (2, 3, 6, 8) et **en ce que** la température de fonctionnement de la lentille (2, 3, 6, 8) est supérieure à 100°C.

5. Système optique suivant au moins une des revendications 1 à 4, **caractérisé en outre en ce qu'**il contient un barreau de verre (4) comme élément de mélange de la lumière et **en ce que** la température de fonctionnement pour le barreau de verre (4) est supérieure à 100°C.

6. Système optique suivant au moins une des revendications 1 à 5, **caractérisé en outre en ce que** le premier élément optique réfractif est constitué de verre de quartz ou de fluorure de calcium.

7. Système optique suivant au moins une des revendications 1 à 6, **caractérisé en outre en ce que** la température de fonctionnement se situe dans la gamme de 150°C à 250°C.

8. Système optique suivant au moins une des revendications 1 à 7, **caractérisé en outre en ce qu'**au moins une partie du système optique est rendue résistante à la chaleur, par d'autres moyens que le premier élément optique réfractif, pour des températures supérieures à 100°C.

9. Procédé de conduite d'un système d'éclairage par projection pour la microlithographie avec une source de lumière ultraviolette (1) et au moins un premier élément optique réfractif (2, 3, 4, 6, 8), **caractérisé en ce que** le premier élément optique réfractif (2, 3, 4, 6) est maintenu à une température de fonctionnement supérieure à 100°C avec un dispositif (10, 11, 21, 22, 23) pour produire cette température de fonctionnement par d'autres moyens que le rayonnement de la source de lumière ultraviolette.

10. Procédé suivant la revendication 9, **caractérisé en outre en ce que** la température de fonctionnement du premier élément optique réfractif (2, 3, 4, 6) est maintenue à une valeur comprise dans la gamme de 150°C à 250°C.

11. Procédé suivant la revendication 9 ou la revendication 10, **caractérisé en outre en ce que** le premier élément optique réfractif (2, 3, 4, 6) est chauffé par rayonnement.
